## Europäisches Patentamt

## European Patent Office

## Office européen des brevets

(19)

(11) Veröffentlichungsnummer: **0 139 230**
**B1**

(12)

# EUROPÄISCHE PATENTSCHRIFT

(45) Veröffentlichungstag der Patentschrift:
**22.06.88**

(51) Int. Cl.⁴: **H 03 H 11/48**

(21) Anmeldenummer: **84111226.1**

(22) Anmeldetag: **20.09.84**

(54) Schaltungsanordnung zur Simulierung eines ungeerdeten Kondensators.

(30) Priorität: **22.09.83 DE 3334243**

(43) Veröffentlichungstag der Anmeldung:
**02.05.85 Patentblatt 85/18**

(45) Bekanntmachung des Hinweises auf die Patenterteilung:
**22.06.88 Patentblatt 88/25**

(84) Benannte Vertragsstaaten:
**AT CH DE FR GB LI NL SE**

(56) Entgegenhaltungen:
ELECTRONICS LETTERS, Band 15, Nr. 21, Oktober 1979, Seiten 688-689, London, GB; D. PATRANABIS et al.: "Novel capacitor floatation scheme"

(73) Patentinhaber: **ALCATEL N.V.,
Strawinskylaan 537 (World Trade Center), NL-1077 XX Amsterdam (NL)**

(84) Benannte Vertragsstaaten: **CH FR GB LI NL SE AT**

(73) Patentinhaber: **Standard Elektrik Lorenz Aktiengesellschaft, Hellmuth-Hirth-Strasse 42, D-7000 Stuttgart 40 (DE)**

(84) Benannte Vertragsstaaten: **DE**

(72) Erfinder: **Dreier, Benno, Landhausstrasse 54, D-7015 Korntal (DE)**

(74) Vertreter: **Villinger, Bernhard, Dipl.-Ing. et al, Standard Elektrik Lorenz AG Patent- und Lizenzwesen Postfach 30 09 29, D-7000 Stuttgart 30 (DE)**

## Beschreibung

Die Erfindung betrifft einen kapazitiven, komplexen Widerstand.

In vielen Anwendungsgebieten, inbesondere bei integrierten Schaltkreisen, besteht die technische Aufgabe, kapazitive Impedanzen so nachzubilden, dass der Kapazitätswert des tatsächlich eingesetzten Kondensators wesentlich geringer ist als die Gesamtkapazität der nach aussen wirksam erscheinenden Impedanz.

Zur Erzeugung solcher Impedanzen sind Kapazitätsmultiplizierer bekannt (z.B. US-A 3 831 117). Ein solcher weist einen Differenzverstärker auf, dessen erster Eingang über einen ersten Widerstand mit einem Eingang der Schaltungsanordnung und dessen zweiter Eingang über einen zweiten Widerstand mit dem Ausgang des Differenzverstärkers verbunden ist. Der Differenzverstärkerausgang ist über einen dritten Widerstand an den Eingang der Schaltungsanordnung angeschlossen. Ferner ist die eine Kapazität enthaltende Impedanz einerseits an den ersten Eingang des Differenzverstärkers und andererseits an ein festes Bezugspotential, üblicherweise das Erdpotential, der Schaltungsanordnung geschaltet. Der Kapazitätsmultiplizierer stellt somit einen Vierpol dar, wobei das kapazitive Bauelement notwendigerweise im Querzweig zum Signalfluss an festem Potential liegt.

Kapazitive, komplexe Impedanzen, die als potentialfreie Zweipole verwendbar sind, d.h. über die üblicherweise ein Wechselstromsignal in beiden Richtungen bei jeweils gleicher Gesamtimpedanz übertragen werden soll, können nicht mit Hilfe dieser, mit festem Potential verbundenen Kapazitätsmultiplizierer realisiert werden.

Die oben genannte technische Aufgabe wird erfindungsgemäss durch die Merkmale des Patentanspruchs 1 gelöst.

Ein Vorteil des kapazitiven, komplexen Widerstands nach der Erfindung, liegt darin, dass diese Schaltung potentialfrei als reiner Zweipol eingesetzt werden kann, der ein Wechselstromsignal in beiden Richtungen überträgt, wobei in beiden Übertragungsrichtungen die gleiche komplexe Gesamtimpedanz wirksam ist.

Vorteilhafte Weiterbildungen der Erfindung sind in den Unteransprüchen angegeben.

Zwei Ausführungsbeispiele werden im folgenden anhand der Zeichnungen näher erläutert. Es zeigen:

Fig. 1 eine übliche Schaltungsanordnung einer komplexen, kapazitiven Impedanz

Fig. 2 ein Blockschaltbild des kapazitiven, komplexen Widerstands Z nach der Erfindung

Fig. 3 eine erste ausführliche Darstellung für einen kapazitiven, komplexen Widerstand nach der Erfindung

Fig. 4 eine zweite ausführliche Darstellung für einen kapazitiven, komplexen Widerstand nach der Erfindung.

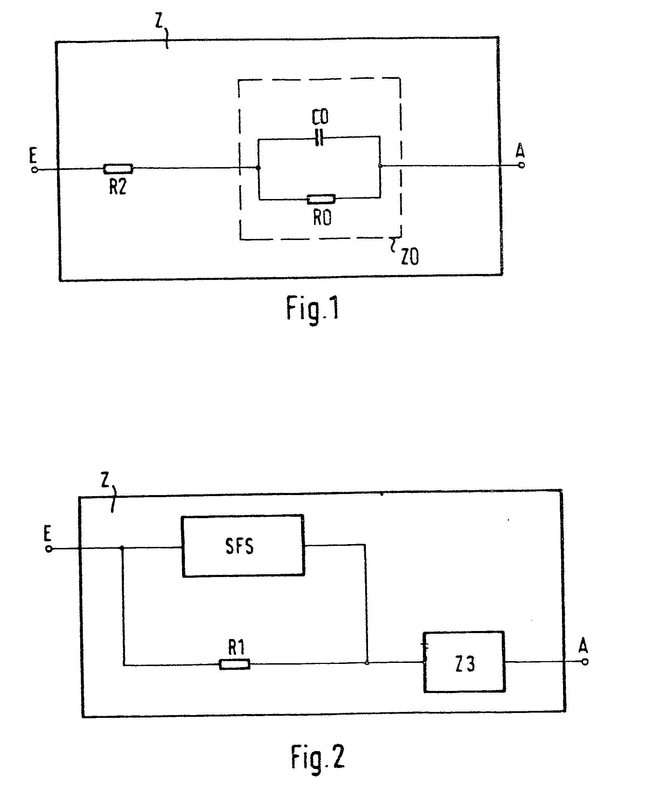

Ein Pol E einer kapazitiven, komplexen Zweipolimpedanz in Figur 1 ist mit einem Widerstand R2 verbunden und über eine in Reihe liegende Impedanz Z0, die aus einem Parallel-RC-Glied R0, C0 besteht, an den anderen Pol A geführt. Der Impedanzwert Z ergibt sich zu

$$Z = R2 + Z0. \tag{1}$$

Das Blockschaltbild in Figur 2 zeigt eine kapazitive, komplexe Impedanz Z, die gemäss der Erfindung eine kapazitive Impedanz Z3 aufweist, die in Reihe mit einem ohmschen Widerstand R1 liegt, welcher von einer Spannungsfolgerschaltung SFS überbrückt ist.

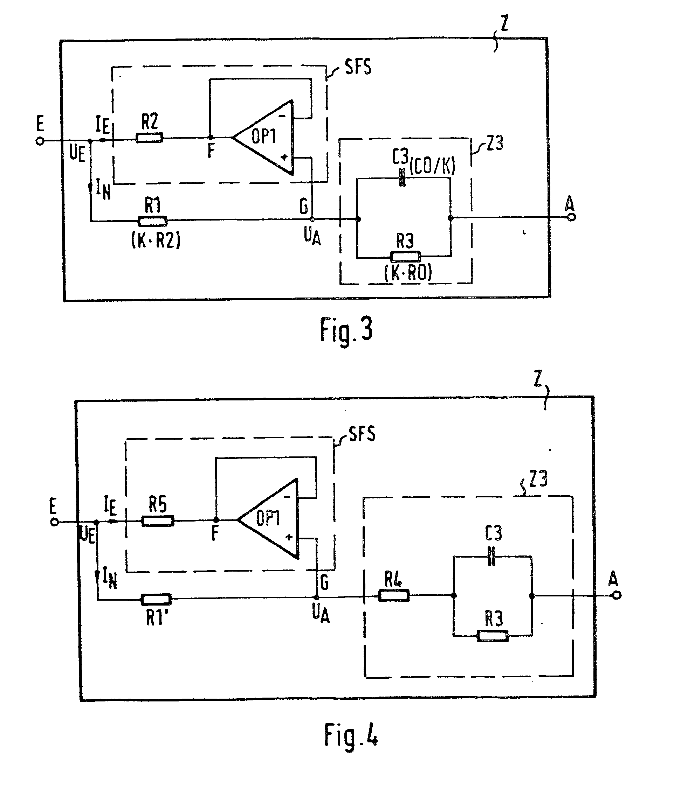

Die Figur 3 zeigt ein erstes detailliertes Ausführungsbeispiel.

Ein Pol A ist mit einer Impedanz Z3, die aus der Parallelschaltung eines Widerstandes R3 und eines Kondensators C3 besteht, verbunden. Die Impedanz Z3 bildet mit einem Widerstand R1 einen Spannungsteiler, dessen Mittelabgriff G mit dem nichtinvertierenden Eingang eines als Spannungsfolger geschalteten Operationsverstärkers OP1 verbunden ist. Der Ausgang F des Operationsverstärkers OP1 ist über den Widerstand R2 mit dem anderen Pol E und der dem Mittelabgriff G abgewandten Seite des Widerstandes R1 verbunden. Gibt man dem Widerstand R1 und der Impedanz Z3 die Werte

$$R1 = K \cdot R2 \tag{2}$$
$$Z3 = K \cdot Z0 \tag{3}$$

so ergeben sich für R3 und C3 die Werte

$$R3 = K \cdot R0 \tag{4}$$
$$C3 = C0/K \tag{5}$$

Um ein möglichst grosses Verhältnis von Impedanzkapazität zur Kapazität der eingesetzten kapazitiven Bauelemente zu erreichen, wird der Faktor K recht gross, beispielsweise K = 100, gewählt. Damit ist der Widerstand R1 wesentlich grösser als der Widerstand R2 und der Strom $I_N$ gegenüber dem Strom $I_E$ vernachlässigbar. Die Berechnung der komplexen, kapazitiven Impedanz vereinfacht sich hierdurch erheblich.

Für die Impedanz Z gilt

$$Z = \frac{U_E}{I_E} \tag{6}$$

wobei

$$I_E = \frac{U_E - U_A}{R2} \tag{7}$$

und das Spannungsteilerverhältnis

$$\frac{U_A}{U_E} = \frac{K \cdot Z0}{K \cdot (R2 + Z0)} \tag{8}$$

eingesetzt in (6) für Z den Wert

$$Z = R2 + Z0 \tag{9}$$

ergibt.

Der in der Schaltungsanordnung nach Figur 1 vorgegebene Impedanzwert Z wird durch die erfindungsgemässe Anordnung nicht verändert. Verändert hat sich aber der Wert der erforderlichen, durch ein Bauelement zu bildenden Kapazität, die jetzt den Wert

$$C3 = C0/K \qquad (10)$$

annimmt, was bei einem grossen Faktor K einer wesentlichen Verkleinerung der ursprünglichen Kapazität C0 entspricht.

Für die Berechnung sind nahezu ausschliesslich grosse Faktoren K von Interesse, da die verwendeten kapazitiven Bauelemente möglichst kleine Kapazitätswerte haben sollten, um eine Ausführung der komplexen, kapazitiven Impedanz Z als integrierte Schaltung zu ermöglichen.

Ein zweites Ausführungsbeispiel ist in Figur 4 angegeben. Hier ist anstatt des gesamten Widerstandes R1 des Spannungsteilers nur ein Teilbetrag des Widerstandes R1, der in Figur 4 als Widerstand R1' dargestellt ist, mit der Spannungsfolgerschaltung SFS überbrückt. Dieser fehlende Betrag des Widerstandes R1 wird als Widerstand R4 in der Impedanz Z3 in Reihe mit dem Parallel-RC-Glied C3, R3 geschaltet. Damit sich nun der Gesamtwert der komplexen, kapazitiven Impedanz Z nicht verändert, und der Widerstand R2 nach (2) und (3) um den Betrag des Widerstandes R4 verkleinert. Dies ergibt einen tatsächlich kleineren Ausgangswiderstand R5 der Schaltung bei einer sich gleichzeitig nicht verändernden Gesamtimpedanz Z. Eine solche Schaltungsvariante kann vorteilhaft eingesetzt werden, wenn ein kleinerer Ausgangswiderstand R5 des Operationsverstärkers OP1 erwünscht ist.

## Patentansprüche

1. Kapazitiver, komplexer Widerstand, dadurch gekennzeichnet, dass ein erster Pol (E) mit einem zweiten Pol (A) des als potentialfreier Zweipol aufgebauten Widerstandes (Z) über eine einen Spannungsteiler bildende Reihenschaltung aus einem ersten ohmschen Widerstand (R1) und einer eine Kapazität (C3) enthaltenden Impedanz (Z3) verbunden ist und dass der erste ohmsche Widerstand (R1) durch eine Spannungsfolgerschaltung (SFS) überbrückt ist, deren Eingang mit einem Mittelabgriff (G) des Spannungsteilers und deren Ausgang mit dem ersten Pol (E) verbunden ist.

2. Kapazitiver, komplexer Widerstand nach Anspruch 1, dadurch gekennzeichnet, dass die Spannungsfolgerschaltung (SFS) aus einem als Spannungsfolger beschalteten Operationsverstärker (OP1) und einem zweiten ohmschen Widerstand (R2) besteht, dass ein nichtinvertierender Eingang (+) und ein invertierender Eingang (−) des Operationsverstärkers (OP1) mit dem Mittelabgriff (G) des Spannungsteilers bzw. mit einem Ausgang (F) des Operationsverstärkers (OP1) verbunden sind und dass der Ausgang (F) über den zweiten Widerstand (R2) mit dem ersten Pol (E) verbunden ist, wobei der Betrag des ersten ohmschen Widerstandes (R1) ein ganzes Vielfaches (K) des Betrages des zweiten ohmschen Widerstandes (R2) beträgt und der Betrag der Kapazität (C3) der Impedanz (Z3) um das gleiche ganze Vielfache kleiner ist als der Betrag der Gesamtkapazität des kapazitiven, komplexen Widerstandes (Z).

## Claims

1. Complex capacitive impedance, characterized in that a first pole (E) is connected to a second pole (A) of the resistor (Z), constructed as a zero-potential dipole, via a series circuit constituting a voltage divider and consisting of a first resistor (R1) and an impedance (Z3) containing a capacitor (C3) and that the first resistor (R1) is shunted by a voltage follower circuit (SFS) whose input is connected to a centre tap (G) of the voltage divider and whose output is connected to the first pole (E).

2. A complex capacitive impedance as claimed in Claim 1, characterized in that the voltage follower circuit (SFS) consists of an operational amplifier (OP1) connected as a voltage follower and a second resistor (R2), that a non-inverting input (+) and an inverting input (−) of said operational amplifier (OP1) are connected to the centre tap (G) of the voltage divider or with an output (A) of said operational amplifier (OP1) and that the output (F) is connected to the first pole (E) via the second resistor (R2), the value of the first resistor (R1) being an integral multiple (K) of the value of the second resistor (R2) and the value of the capacitor (C3) of the impedance (Z3) being smaller by the same integral multiple than the value of the total capacitance of the complex capacitive impedance (Z).

## Revendications

1. Résistance capacitive complexe caractérisée en ce qu'une première borne (E) et une deuxième borne (A) d'une résistance (Z) constituant un dipôle à potentiel flottant sont connectées l'une à l'autre par un circuit série formant diviseur de tension et comprenant une première résistance ohmique (R1) et une impédance (Z3) comprenant une capacité (C3) et en ce que la première résistance ohmique (R1) est shuntée par un circuit suiveur de tension (SFS) dont l'entrée est connectée à une prise intermédiaire (G) du diviseur de tension et dont la sortie est connectée à ladite première borne (E).

2. Résistance capacitive complexe conforme à la revendication 1, caractérisée en ce que le circuit suiveur de tension (SFS) comporte un amplificateur opérationnel (OP1) connecté en suiveur de tension et une deuxième résistance ohmique (R2), en ce qu'une entrée non inverseuse (+) et une entrée inverseuse (−) de l'amplificateur opérationnel (OP1) sont respectivement connectées à la prise intermédiaire (G) du diviseur de tension et à une sortie (F) de l'amplificateur opérationnel (OP1) et en ce que ladite sortie (F) est connectée par la deuxième résistance (R2) à ladite première borne (E), la valeur de la première résistance ohmique (R1) étant un multiple entier (K) de la valeur de la deuxième résistance ohmique (R2) et la valeur de la capacité (C3) de l'impédance (Z3) est inférieure dans le même rapport multiple entier à la valeur de la capacité totale de la résistance capacitive complexe (Z).

Z

CO

E

R2

A

RO

ZO

Fig.1

Z

E

SFS

R1

Z3

A

Fig.2

Fig. 3

Fig. 4